# EUROPÄISCHE PATENTANMELDUNG

(11) **EP 0 797 381 A2**
(43) Veröffentlichungstag der Anmeldung: **24.09.1997**
(21) Anmeldenummer: 97102347.8
(22) Anmeldetag: 13.02.1997
(51) Int. Cl.: H05K 3/28, H05K 1/02

(54) **Vergossene, leiterplattenlose elektrische/elektronische Baugruppe**

(30) Priorität: 26.02.1996 DE 19607194
(71) Anmelder: SIEMENS AKTIENGESELLSCHAFT, 80333 München (DE)
(72) Erfinder: Trummer, Georg, Dipl.-Ing., 92224 Amberg (DE); Jungmann, Eginhard, 81925 München (DE)

(57) **Zusammenfassung**

Der mit der vorliegenden Erfindung angestrebte kostenoptimale Aufbau einer elektrischen und/oder elektronischen Baugruppe (2) wird dadurch erreicht, daß ein Vergußmedium (6) die stabilisierende Funktion einer bisher erforderlichen Leiterplatte übernimmt, die damit entfallen kann. Mit dem Vergießen wird also der leiterplattenlose Aufbau einer Baugruppe (2) erreicht. Das verfestigte Vergußmedium (6) kann gleichzeitig neben der schützenden Funktion eines bisher erforderlichen Gehäuses, welches damit gleichfalls entfallen kann, auch die Wärmeableitung sowie den Schutz gegen elektromagnetische Ein- bzw. Abstrahlungen übernehmen.

## Beschreibung

Die vorliegende Erfindung betrifft eine elektrische und/oder elektronische Baugruppe, mit Bauelementen, die untereinander elektrisch leitend verbunden sind, wobei die Bauelemente sowie die elektrisch leitenden Verbindungen in ein verfestigtes Vergußmedium eingebettet sind.

Heute bestehen Baugruppen im Regelfall aus einem Gehäuse, einer Leiterplatte sowie auf der Leiterplatte angeordneten Bauelementen mit elektrisch leitenden Verbindungen zwischen diesen Bauelementen. Unter dem Begriff "Bauelemente" werden dabei sowohl "interne Bauelemente" - wie z.B. Widerstände, Dioden, Transistoren etc. - als auch "externe Bauelemente" - wie z.B. Steckverbindungen, Kontaktelemente, Schaltelemente etc. - verstanden.

Eine derartige Baugruppe, die in ein verfestigtes Vergußmedium - in diesem Falle in ein Harz - eingebettet ist, ist z.B. aus der EP 0 505 271 B1 bekannt. Die dort beschriebene Baugruppe besteht aus einem Gehäuse, das zur Aufnahme von elektrischen Bauelementen, insbesondere eines Annäherungsdetektors, geeignet ist. Die Bauelemente sind in erhärtetes Isolierharz eingebettet. Durch das Isolierharz, welches mechanisch an der Innenwand des Gehäuses haftet, sind sie z.B. unempfindlich gegen Schwingungen und Stöße.

Die Einbettung der Bauelemente in ein Vergußmedium wird eingesetzt, um - im weitesten Sinne - die Bauelemente zu schützen. Die Reduktion der Kosten einer Baugruppe durch deren Einbettung in ein Vergußmedium ist durch die EP 0 505 271 B1 ersichtlich nicht angestrebt.

Die Aufgabe der vorliegenden Erfindung besteht darin, einen kostenoptimalen Aufbau einer elektrischen und/oder elektronischen Baugruppe zu gewährleisten.

Die Aufgabe wird dadurch gelöst, daß die Baugruppe leiterplattenlos ausgebildet ist und daß die elektrisch leitenden Verbindungen durch das Vergußmedium stabilisiert sind.

Es werden also diejenigen Bestandteile der Baugruppe, die einer Kostenoptimierung zugänglich sind, durch preiswerte Materialien ersetzt bzw. entfallen ersatzlos.

Der Erfindung liegt die Erkenntnis zugrunde, daß bei einfachen Baugruppen - mit vorzugsweise wenigen oder einfachen Bauelementen - der Kostenfaktor der Bauelemente in den Hintergrund tritt. Die Kosten werden in diesem Falle vor allem durch das Gehäuse sowie ganz besonders durch die unbestückte Leiterplatte bestimmt. Bei diesen beiden Bestandteilen der Baugruppe sind Kostenoptimierungen prinzipiell möglich. Dagegen ist die Art und die Anzahl der Bauelemente bereits durch die beabsichtigte Funktion der Baugruppe festgelegt. Bezüglich dieser Bestandteile der Baugruppe bestehen also keine weiteren Optimierungsmöglichkeiten.

Durch das Vergießen der Baugruppe wird zunächst erreicht, daß die zuvor benötigte Leiterplatte entfallen kann.

Darüber hinaus übernimmt das verfestigte Vergußmedium gleichzeitig auch die schützende Funktion eines Gehäuses. Somit kann zusätzlich auch das Gehäuse - als weiterer, zuvor vorhandener Kostenfaktor - entfallen.

Vorteilhafterweise sind die Bauelemente in einer Ausgestaltung der Erfindung auf einem elektrisch isolierenden Träger aufgebracht, welcher die elektrisch leitenden Verbindungen stabilisiert, bis das Vergußmedium verfestigt ist, so daß unerwünschte Kontaktierungen praktisch ausgeschlossen sind. Solche Kontaktierungen sind unerwünscht, da sie die ordnungsgemäße Funktion der Baugruppe beeinträchtigen. Zudem wären sie in dem verfestigten Vergußmedium irreversibel. Sie würden die Baugruppe im vergossenen Zustand wertlos machen. Die auf diese Weise erzielte Vorstabilisierung der Baugruppe ist insbesondere für Baugruppen oberhalb einer gewissen räumlichen Dimension nützlich, denn mit zunehmender räumlicher Dimension wächst die Gefahr einer unerwünschten Verformung der Baugruppe - z.B. beim Einlegen in die Gußform. Eine solche Verformung könnte dazu führen, daß die elektrisch leitenden Verbindungen, die bei elektrischen/elektronischen Baugruppen üblicherweise nicht isoliert sind, in unerwünschter Weise miteinander in Kontakt kommen.

Wenn die Baugruppe eine EMV-Abschirmung aufweist, ist die Baugruppe gegen Einstrahlungen geschützt, welche die ordnungsgemäße Funktion der Baugruppe beeinträchtigen konnten. Selbstverständlich sind in diesem Falle auch andere Baugruppen gegen Einstrahlungen aus speziell dieser Baugruppe geschützt, da die EMV-Abschirmung auch unerwünschte Abstrahlungen der Baugruppe selbst unterdrückt. Dies ist insbesondere von Vorteil, wenn mehrere der beschriebenen Baugruppen auf engem Raum plaziert werden.

Die EMV-Abschirmung der Baugruppe kann dadurch erreicht werden, daß auf dem erhärteten Vergußmedium eine elektrisch leitende Beschichtung aufgebracht ist. Alternativ kann die EMV-Abschirmung der Baugruppe auch dadurch erreicht werden, daß sie durch das Vergußmedium selbst gebildet ist, welches die dazu notwendigen dielektrischen Eigenschaften besitzt.

Weitere Vorteile und Einzelheiten ergeben sich aus den nachfolgend beschriebenen Ausführungsbeispielen. Dabei zeigt:
- FIG 1: in der Draufsicht eine in eine Gußform gelegte Baugruppe,
- FIG 2: die Seitenansicht einer vergossenen Baugruppe in einer Gußform,
- FIG 3: eine vergossene Baugruppe mit einer Beschichtung des Vergußmediums,
- FIG 4: bedrahtete Bauelemente und SMD-Bauelemente, die auf einem Träger aufgebracht sind und
- FIG 5: auf einem Träger aufgebrachte Leiterbahnen.

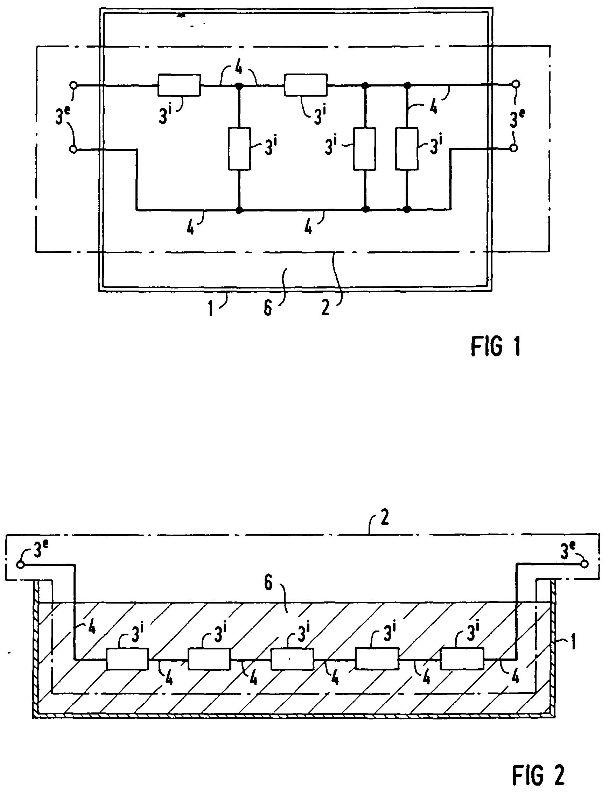

Gemäß FIG 1 ist eine Baugruppe 2 mit Bauelementen 3 sowie den untereinander bestehenden elektrisch leitenden Verbindungen 4 in eine Gußform 1 gelegt. Die Bauelemente 3 sind dabei sowohl interne Bauelemente 3ⁱ, wie z.B. Widerstände, Dioden, Transistoren etc., als auch externe Bauelemente 3^{e}, wie z.B. Steckverbindungen, Kontaktelemente, Schaltelemente etc. Dabei werden die externen Bauelemente 3^{e} insbesondere für eine Peripherie- oder Busanbindung sowie im Falle von Schaltelementen für die Bedienung der Baugruppe 2 benötigt.

Die Darstellung in FIG 1 ist derart, daß der Betrachter in die oben offene Gußform 1 hinein und damit gleichzeitig von oben auf die Baugruppe 2 schaut. Die Gußform 1 wird mit einem Vergußmedium 6 gefüllt, so daß das Vergußmedium 6 die Baugruppe 2 mit Ausnahme der externen Bauelemente 3^{e} einschließt.

Die geometrische Form der Gußform 1 ist selbstverständlich nicht auf die dargestellte quaderförmige Ausbildung beschränkt. Vielmehr wird je nach Bedarf eine jeweils geeignete geometrische Form ausgewählt. Auf diese Weise ist gewährleistet, daß die Form der vergossenen Baugruppe 2 den jeweiligen Erfordernissen - z.B. dem zur Verfügung stehenden Raum - am Anbringungsort angepaßt ist. Weiterhin sind die nicht dargestellten Befestigungspunkte der vergossenen Baugruppe 2 jederzeit so wählbar wie dies für die angestrebte Anbringung erforderlich ist.

Der exemplarisch - durch die miteinander verbundenen Bauelemente 3ⁱ,3^{e} - dargestellte Aufbau der Baugruppe 2 ist willkürlich gewählt. Charakteristisch ist jedoch, daß die externen Bauelemente 3^{e} aus dem verfestigten Vergußmedium 6 herausragen oder aber an dessen Oberfläche liegen.

FIG 2 zeigt in einer Seitenansicht die in der Gußform 1 liegende Baugruppe 2. Die Baugruppe 2 besteht aus internen Bauelementen 3ⁱ und externen Bauelementen 3^{e}, sowie den zwischen diesen bestehenden elektrisch leitenden Verbindungen 4. Gemäß dieser FIG 2 schließt das Vergußmedium 6 die internen Bauelemente 3ⁱ vollständig und die externen Bauelemente 3^{e} der Baugruppe 2 höchstens teilweise ein.

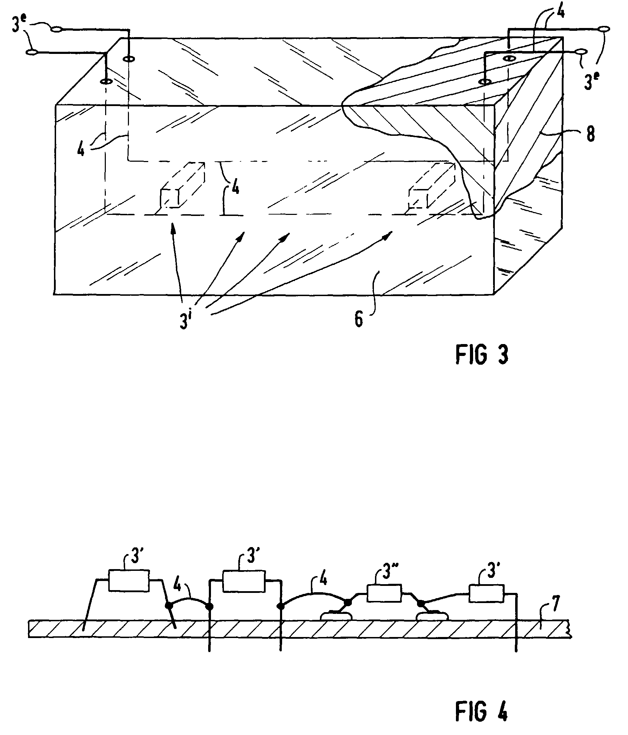

Nachdem das Vergußmedium 6 verfestigt ist, wird die in das Vergußmedium 6 eingebettete Baugruppe 2 aus der Gußform 1 entfernt. FIG 3 zeigt eine solche Baugruppe 2. Das verfestigte Vergußmedium 6 übernimmt für die eingebettete Baugruppe 2 die Funktion eines Gehäuses, denn durch das Vergußmedium 6 sind die Bauelemente 3 in ähnlicher Weise wie durch ein Gehäuse gegen mechanische Belastungen und flüssige oder atmosphärische Umwelteinflüsse geschützt.

Die Baugruppe 2 ist gegen störende Einstrahlungen durch eine EMV-Abschirmung geschützt. Die EMV-Abschirmung verhindert auch unerwünschte Abstrahlungen der Baugruppe 2 selbst, so daß auch andere Baugruppen 2 gegen Einstrahlungen aus speziell dieser Baugruppe 2 geschützt sind. FIG 3 zeigt die - nur teilweise dargestellte - Beschichtung 8 der Oberfläche des Vergußmediums 6 mit einem elektrisch leitenden Material, z.B. Kupfer, Zinn, etc. Mit dieser Beschichtung 8, die in der praktischen Realisierung im wesentlichen über die gesamte Oberfläche des verfestigten Vergußmediums 6 ausgedehnt ist, ist die angestrebte EMV-Abschirmung gewährleistet.

In einer nicht dargestellten Alternative kann die EMV-Abschirmung der Baugruppe 2 auch dadurch erreicht werden, daß sie durch das Vergußmedium 6 selbst gebildet ist, welches die dazu notwendigen dielektrischen Eigenschaften besitzt. Als Vergußmedien 6 kommen in diesem Falle z.B. die sogenannten ABS-Kunststoffe zum Einsatz, die sich in wechselnden Anteilen aus Acryl, Butadien und Styrol zusammensetzen.

In einer speziellen, nicht dargestellten Ausprägung ist das Vergußmedium 6 als elastisches Vergußmedium ausgebildet, so daß die vergossene Baugruppe 2 elastisch verformbar ist. Als Vergußmedien 6 kommen in diesem Falle z.B. die ABS-Kunststoffe oder Gummi etc. zum Einsatz.

In einer weiteren speziellen, nicht dargestellten Ausprägung weist das Vergußmedium 6 eine Wärmeleitfähigkeit derart auf, daß die auf der vergossenen Baugruppe 2 im Betrieb entstehende Verlustwärme hinreichend abgeleitet wird. Auch in diesem Falle können als Vergußmedien die ABS-Kunststoffe zum Einsatz kommen.

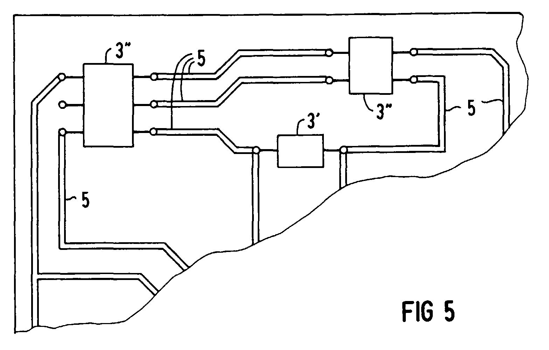

FIG 4 zeigt in einer Seitenansicht Bauelemente 3', 3'', die auf einen elektrisch isolierenden, durchdringbaren Träger 7 aufgebracht sind. Ein solcher Träger ist z.B. aus Polystyrol, Schaumgummi, etc.

Bedrahtete Bauelemente 3' sind durch den Träger hindurchgesteckt oder in ihn hineingesteckt. SMD-Bauelemente 3'' sind - wie auch bisher bei Leiterplatten üblich - auf den Träger 7 aufgeklebt. Die Bauelemente 3', 3'' sind demnach jeweils auf dem Träger 7 fixiert und damit vorstabilisiert. Zwischen den Bauelementen 3', 3'' bestehen elektrisch leitende Verbindungen 4. Diese Verbindungen 4 sind durch ein Verbindungsmittel, z.B. ein Kabel, eine Litze etc., hergestellt. Der Träger 7 stabilisiert demnach auch diese Verbindungen 4, bis das Vergußmedium 6 verfestigt ist.

Wie in FIG 4 auf der rechten Seite ersichtlich, sind die Bauelemente 3', 3'' zumindest teilweise direkt miteinander verbunden, z.B. durch Löten oder Bonden.

In einer nicht dargestellten Alternative sind die Bauelemente 3 auf einem elektrisch isolierenden, undurchdringbaren Träger 7 aufgebracht, welcher die elektrisch leitenden Verbindungen 4 stabilisiert, bis das Vergußmedium 6 verfestigt ist. Diese Alternative ist nützlich, da der Träger 7 lediglich durch die isolierende Eigenschaft ausgezeichnet ist. Für einen solchen Träger 7 wird z.B. das gleiche Material wie für das Vergußmedium 6 verwendet. Wenn durch einen solchen Träger 7 eine ausreichende Stabilisierung der Baugruppe 2 gewährleistet ist, kann auf die zusätzliche Fixierung der Bauelemente 3 - wie oben beschrieben - ohne weiteres verzichtet werden.

Eine Baugruppe 2 gemäß FIG 4 wird - analog zu FIG 1 und FIG 2 - zusammen mit dem Träger 7 in eine Gußform 1 gelegt und zusammen mit dem Träger 7 vergossen. Das Vergußmedium 6 schließt also im Falle der Verwendung eines Trägers 7 die Baugruppe 2 zusammen mit diesem Träger 7 ein.

FIG 5 zeigt Leiterbahnen 5, die auf einem Träger 7 aufgebracht sind. In einer speziellen Ausprägung sind die Leiterbahnen 5 z.B. mit Graphit auf den Träger 7 aufgedruckt. Auch mit Hilfe dieser Leiterbahnen 5 werden elektisch leitende Verbindungen 4 zwischen den Bauelementen 3 erreicht.

Der mit der vorliegenden Erfindung angestrebte kostenoptimale Aufbau einer elektrischen und/oder elektronischen Baugruppe 2 wird dadurch erreicht, daß das Vergußmedium 6 die stabilisierende Funktion der bisher erforderlichen Leiterplatte übernimmt, die damit entfallen kann. Mit dem Vergießen wird also der leiterplattenlose Aufbau einer Baugruppe 2 erreicht. Das verfestigte Vergußmedium 6 kann gleichzeitig auch die schützende Funktion des bisher erforderlichen Gehäuses übernehmen, welches damit gleichfalls entfallen kann. Weiterhin bewirkt das beschriebene Vergießen einer Baugruppe 2 zwangsläufig eine hohe Schutzart (IP65 oder besser) sowie eine hohe mechanische Festigkeit, womit sich ein weiterer wichtiger Vorteil der vorliegenden Erfindung ergibt. Durch die geeignete Wahl bestimmter Materialien als Vergußmedium 6 wird vorteilhafterweise weiterhin eine EMV-Abschirmung, eine Ableitung der Verlustwärme sowie eine elastische Verformbarkeit der der vergossenen Baugruppe 2 erreicht.

## Patentansprüche

1. Baugruppe, mit Bauelementen (3), die untereinander leiterplattenlos elektrisch leitend verbunden sind, wobei die elektrisch leitenden Verbindungen (4) durch ein verfestigtes Vergußmedium (6) stabilisiert sind, in das die Bauelemente (3) sowie die elektrisch leitenden Verbindungen (4) eingebettet sind.

2. Baugruppe nach Anspruch 1,
**dadurch gekennzeichnet,** daß
die Bauelemente (3) auf einem elektrisch isolierenden Träger (7) angeordnet sind, welcher die elektrisch leitenden Verbindungen (4) stabilisiert, bis das Vergußmedium (6) verfestigt ist.

3. Baugruppe nach Anspruch 2,
**dadurch gekennzeichnet,** daß
die elektrisch leitenden Verbindungen (4) zumindest teilweise als auf dem Träger (7) aufgebrachte Leiterbahnen (5) ausgebildet sind, z.B. mit Graphit gedruckt.

4. Baugruppe nach Anspruch 2 oder 3,
**dadurch gekennzeichnet,** daß
die Bauelemente (3) zumindest teilweise als SMD-Bauelemente (3'') ausgebildet und daß die SMD-Bauelemente (3'') auf den Träger (7) aufgeklebt sind.

5. Baugruppe nach Anspruch 2, 3 oder 4,
**dadurch gekennzeichnet,** daß
der Träger (7) durchdringbar ist, daß die Bauelemente (3) zumindest teilweise als bedrahtete Bauelemente (3') ausgebildet sind und daß die bedrahteten Bauelemente (3') durch den Träger (7) hindurchgesteckt oder in ihn hineingesteckt sind.

6. Baugruppe nach einem der obigen Ansprüche,
**dadurch gekennzeichnet,** daß
der Träger (7) aus Polystyrol ist.

7. Baugruppe nach einem der obigen Ansprüche,
**dadurch gekennzeichnet,** daß
die Bauelemente (3, 3', 3'') zumindest teilweise untereinander direkt verbunden sind.

8. Baugruppe nach einem der obigen Ansprüche,
**dadurch gekennzeichnet,** daß
die Baugruppe (2) eine EMV-Abschirmung aufweist.

9. Baugruppe nach Anspruch 8,
**dadurch gekennzeichnet,** daß
die EMV-Abschirmung als elektrisch leitende Beschichtung (8) des erhärteten Vergußmediums (6) ausgebildet ist.

10. Baugruppe nach Anspruch 8,
**dadurch gekennzeichnet,** daß
die EMV-Abschirmung durch das Vergußmedium (6) selbst gebildet ist.

11. Baugruppe nach einem der obigen Ansprüche,
**dadurch gekennzeichnet,** daß
das Vergußmedium (6) eine Warmeleitfähigkeit derart aufweist, daß die auf der vergossenen Baugruppe (2) im Betrieb entstehende Verlustwärme hinreichend abgeleitet wird.

12. Baugruppe nach einem der obigen Ansprüche,
**dadurch gekennzeichnet,** daß
das Vergußmedium (6) als elastisches Vergußmedium (6) ausgebildet ist, so daß die Baugruppe (2) elastisch verformbar ist.

13. Baugruppe nach einem der obigen Ansprüche,
**dadurch gekennzeichnet,** daß
das verfestigte Vergußmedium (6) die Funktion eines Gehäuses übernimmt.
